# EUROPÄISCHE PATENTSCHRIFT

(11) **EP 1 135 540 B1**
(45) Veröffentlichungstag und Bekanntmachung des Hinweises auf die Patenterteilung: **13.03.2002**
(21) Anmeldenummer: 99970697.1
(22) Anmeldetag: 21.10.1999
(51) Int. Cl.: C23C 14/02, C23G 5/00

(54) **VERFAHREN UND VORRICHTUNG ZUR REINIGUNG EINES ERZEUGNISSES**
METHOD AND DEVICE FOR CLEANING A PRODUCT
PROCEDE ET DISPOSITIF POUR LE NETTOYAGE D'UN PRODUIT

(30) Priorität: 21.10.1998 EP 98119920
(43) Veröffentlichungstag der Anmeldung: 26.09.2001
(73) Patentinhaber: SIEMENS AKTIENGESELLSCHAFT, 80333 München (DE)
(72) Erfinder: DÖPPER, Gebhard, D-52066 Aachen (DE)
(86) Internationale Anmeldenummer: EP9907997
(87) Internationale Veröffentlichungsnummer: WO0023634

(56) Entgegenhaltungen:
- DE-C- 4 228 499
- DE-C- 19 500 262
- GB-A- 1 447 754
- GB-A- 2 323 855
- US-A- 4 500 564
- PATENT ABSTRACTS OF JAPAN vol. 009, no. 211 (C-300), 29. August 1985 (1985-08-29) & JP 60 077970 A (SUMITOMO DENKI KOGYO KK), 2. Mai 1985 (1985-05-02)

## Beschreibung

Die Erfindung betrifft ein Verfahren zur Oberflächenreinigung eines Erzeugnises, insbesondere eines Bauteils einer thermischen Maschine, wie einer Gasturbinenschaufel oder eines Hitzeschildelements, welches einen metallischen Grundkörper aufweist. Die Erfindung betrifft weiter ein Verfahren zum Aufbringen einer Beschichtung, insbesondere einer Wärmedämmschicht, auf ein Erzeugnis, welches einem heißen aggressiven Gas aussetzbar ist und einen metallischen Grundkörper aufweist. Weiterhin betrifft die Erfindung eine Vorrichtung zur Reinigung eines Erzeugnisses, die eine Substratkammer mit einer darin befindlichen Substratführung und mit einem Substrathalter aufweist.

Aus der US-PS 5,238,752 ist ein Wärmedämmschichtsystem mit einem intermetallischen Haftvermittlungsüberzug bekannt. Das Wärmedämmschichtsystem ist auf einem metallischen Grundkörper aufgebracht, insbesondere auf einem Cr-Co-Stahl für eine Flugtriebwerksschaufel. Unmittelbar auf diesem metallischen Grundkörper ist eine intermetallische Haftvermittlungsschicht, insbesondere aus einem Nickelaluminid oder einem Platinaluminid, aufgebracht. An diese Haftvermittlungsschicht schließt sich eine dünne keramische Schicht aus Aluminiumoxid an, auf die die eigentliche Wärmedämmschicht, insbesondere aus mit Yttrium stabilisiertem Zirkonoxid, aufgetragen ist. Diese keramische Wärmedämmschicht aus Zirkonoxid hat eine stabförmige Struktur, wobei die stabförmigen Stengel im wesentlichen senkrecht zur Oberfläche des Grundkörpers gerichtet sind. Hierdurch soll eine Verbesserung der zyklischen thermischen Belastungsfähigkeit gewährleistet sein. Die Wärmedämmschicht wird mittels eines Elektronenstrahl-PVD (Physical Vapour Deposition)-Verfahrens auf dem Grundkörper abgeschieden, wobei mit einer Elektronenstrahlkanone aus einem metalloxidischen Körper Zirkonoxid verdampft wird. Das Verfahren wird in einer entsprechenden Vorrichtung durchgeführt, in der der Grundkörper auf eine Temperatur von etwa 950° C bis 1000° C vorgeheizt wird. Der Grundkörper wird während des Beschichtungsvorgangs in dem Strahl aus dem Metalloxid mit einer konstanten Geschwindigkeit rotiert.

Ein Elektronenstrahl-PVD-Verfahren zur Herstellung eines keramischen Überzuges ist weiterhin in der US-PS 5,087,477 beschrieben. Die erzeugte keramische Schicht weist hier eine Schichtdicke zwischen 250 bis 375 µm auf.

Für eine gute Haftung zwischen der Beschichtung und dem Grundkörper ist eine Reinigung des Grundkörpers vor der Beschichtung von Vorteil. Aus der GB 2 323 855 sowie der GB 1 447 754 ist jeweils bekannt, ein zu beschichtendes Erzeugnis vor der Beschichtung zu reinigen. Die Reinigung erfolgt hierbei jeweils mittels eines Sputterverfahrens, bei dem zunächst ein Plasma erzeugt wird und bei dem die positiven Ionen des Plasmas in Richtung zum Grundkörper beschleunigt werden. Die Vorrichtung zur Reinigung des Grundkörpers ist in der Vorrichtung zur Beschichtung des Grundkörpers integriert. Zur Erwärmung des Grundkörpers auf eine geeignete Beschichtungstemperatur wird der Grundkörper mit Hilfe eines Elektronenstrahls aufgeheizt. Es ist vorgesehen, dass zwischen der Aufheizphase mittels des Elektronenstrahls und der Reinigungsphase mittels Ionenbeschuß umgeschaltet werden kann. Hierzu ist es notwendig, dass die Potentialbeziehung zwischen dem Grundkörper und der Elektronenquelle bzw. den positiven Ionen des Plasmas eingestellt oder gesteuert wird. Die GB 2 323 855 sieht hierzu vor, den Grundkörper mit einer Spannungsquelle zu verbinden, um den Grundkörper auf ein geeignetes Potential einzustellen. In der GB 1 447 754 sind ebenfalls eine Spannungsquelle sowie eine Kontrolleinrichtung vorgesehen, um die Potentialbeziehungen zwischen Grundkörper, Elektronenquelle und Plasma beeinflussen zu können. Zur Einstellung einer geeigneten Potentialbeziehung ist also nach beiden Literaturstellen eine aktive Spannungsversorgung notwendig.

Aufgabe der Erfindung ist es, ein gegenüber dem Stand der Technik verbessertes Verfahren zur Reinigung eines Erzeugnisses, insbesondere eines Bauteils einer Gasturbine, anzugeben im Hinblick auf einen für das Erzeugnis vorgesehenen Beschichtungsprozeß. Eine weitere Aufgabe der Erfindung besteht in der Angabe eines Verfahrens zur Beschichtung eines Erzeugnisses mit einer Schutzschicht und/oder einer Wärmedämmschicht-. Eine zusätzliche Aufgabe der Erfindung besteht in der Angabe einer Vorrichtung zur Reinigung und/oder zum Beschichten eines Erzeugnisses.

Erfindungsgemäß wird die auf ein Verfahren zur Reinigung der Oberfläche eines Erzeugnisses, welches einen metallischen Grundkörper aufweist, gerichtete Aufgabe dadurch gelöst, daß ein Plasma mit elektrisch positiv geladenen Ionen erzeugt wird und die Ionen in Richtung des Erzeugnisses beschleunigt werden, so daß sie auf dem Grundkörper zum Zwecke der Reinigung auftreffen, wobei ein Elektronenstrahl auf den Grundkörper gerichtet wird, und daß der Abfluß von auf den Grundkörper auftreffenden Elektronen gesteuert wird, indem der Grundkörper über einen Schalter mit fest vorgegebener, mit einstellbarer oder mit geregelter Frequenz mit einem Bezugspotential verbunden wird.

Mit diesem Verfahren wird die Oberfläche des Erzeugnisses, insbesondere eines Bauteils in einem Plasma, derart vorgereinigt, daß die Haftung aufzudampfender Schichten deutlich verbessert ist gegenüber einem Verfahren mit thermischer Reinigung. Durch das letztere kann es beispielsweise zu einer Entgasung kommen.

Das hier angegebene Verfahren hat gegenüber den aus dem Stand der Technik bekannten Verfahren den entscheidenden Vorteil, dass es deutlich einfacher und damit auch weniger störanfallig ist. Denn über die zu- und abschaltbare Verbindung des Grundkörpers mit dem Bezugspotential, welches beispielsweise Massepotential oder Erdpotential ist, ist in einfacher Weise eine geeignete Einstellung der Potentialbeziehung zwischen Grundkörper und Plasma sowie den Elektronen des Elektronenstrahls möglich. Über die Verbindung mit dem Bezugspotential wird also das elektrische Potential des Grundkörpers gesteuert. Der Abfluß kann hierbei zwischen einem maximalen Wert und einem minimalen Wert gesteuert werden, wobei der minimale Wert vorzugsweise Null beträgt, d.h. daß kein Abfluß von Elektronen stattfindet. In letzterem Falle fließen die Elektronen nicht ab, und es wird ein Elektronenstau um das Erzeugnis herum erzeugt, der das Erzeugnis negativ auflädt. Bei Anwesenheit des Plasmas werden die positiv geladenen Ionen zum Erzeugnis hin beschleunigt; sie treffen mit einer parameterabhängigen Geschwindigkeit auf dem Erzeugnis auf. Über einen Impulsaustausch mit der Oberfläche des Erzeugnisses werden dort vorhandene Verunreinigungen abgetragen.

Wird hingegen der Abfluss auf einen maximalen Wert eingestellt, d.h. wird der Schalter geschlossen und wird der Grundkörper mit dem Bezugspotential, beispielsweise Massepotential, verbunden, so können die Elektronen des Elektronenstrahls ungehindert abfließen. Die positiven Ionen des Plasmas werden demzufolge nicht in Richtung zum Grundkörper hin beschleunigt. Das Erzeugnis ist bei geschlossenem Schalter daher im Wesentlichen nur dem Elektronenstrahl ausgesetzt, der das Erzeugnis erwärmt. Durch Betätigen des Schalters kann somit in einfacher Weise zwischen einer Reinigungsphase und einer Aufheizphase umgeschaltet werden. Dabei kann der Schalter in geeigneter Weise mit einer fest vorgegebenen, mit einer einstellbaren oder mit einer geregelten Frequenz betätigt werden.

Vorzugsweise findet der Abfluß von Elektronen über eine elektrische Ableitung statt, die über den Schalter abwechselnd geöffnet und geschlossen wird. Durch die Ableitung ist ein Strompfad realisiert, der ständig zwischen Durchgang und Sperrung hin- und hergeschaltet werden kann. Die Wechselschaltung zwischen Durchgang und Sperrung des Strompfades kann mit einer konstanten, gegebenenfalls zeitlich veränderbaren Frequenz erfolgen. Durch eine Wechselschaltung kommt es zu einer wechselnden Ladung und Entladung des Erzeugnisses, durch die unter Anwesenheit eines Gases eine Wechselspannungsentladung (Plasma) gezündet bzw. aufrechterhalten werden kann. Auf diese Weise ist eine ständige Reinigung des Bauteils realisiert.

Die Frequenz, mit der der Abfluß von Elektronen gesteuert wird, kann hierbei zwischen einigen wenigen Hertz und Frequenzen bis in den Megahertzbereich liegen, insbesondere kann die Frequenz etwa 50 kHz oder bei etwa 27 MHz betragen. Die hochfrequente Umschaltung hat den entscheidenden Vorteil, dass bei geeigneten Hochfrequenzen der Reinigungseffekt unabhängig von der Bauteilgeometrie ist. Die hochfrequente Umschaltung erlaubt daher eine zuverlässige und insbesondere homogene Reinigung des Erzeugnisses.

Zwischen dem Plasma und dem Grundkörper besteht eine Potentialdifferenz, d.h. eine elektrische Spannung, welche durch eine entsprechende Steuerung des Abflusses von Elektronen von dem Grundkörper beeinflußbar, insbesondere einstellbar, ist.

Diese Potentialdifferenz ergibt eine Vorspannung in einem Bereich von etwa 100 V bis etwa über 1000 V. Diese Vorspannung kann so gewählt werden, daß die Bildung des Plasmas, insbesondere durch eine Wechselspannungsentladung, gezündet und aufrechterhalten werden kann.

Vorzugsweise wird die Vorspannung zwischen den elektrisch positiv geladenen Ionen des Plasmas und dem Grundkörper bestimmt und kann gegebenenfalls zur Steuerung des Abflusses der Elektronen verwendet werden. Es ist somit möglich, auch einen Regelprozeß zwischen Vorspannung und Abfluß der Elektronen im Hinblick auf einen möglichst günstige Reinigung des Erzeugnisses je nach Art des metallischen Grundkörpers (geometrische Form, metallurgische Zusammensetzung etc.) durchzuführen. Die Vorspannung (auch als BIAS-Spannung bezeichnet) wird hierbei vorzugsweise zeitlich gemittelt gemessen und angezeigt.

Das Plasma wird vorzugsweise durch einen Elektronenstrahl erzeugt, insbesondere durch den Elektronenstrahl, der auf den Grundkörper gerichtet ist und unter anderem auch der Beheizung des Erzeugnisses dienen kann. Der Elektronenstrahl kann dabei fächerförmig oder kegelförmig als Elektronenstrahlfächer bzw. -kegel ausgebildet sein, um den Grundkörper flächig bestrahlen zu können und ein hinreichend großes Plasmavolumen zu erzeugen. Es ist ebenfalls möglich, das Plasma in einem separaten Prozeß zu erzeugen und das bereits ionisierte Plasma in die Umgebung des Erzeugnisses zu leiten. Als Gas, aus dem das Plasma gebildet wird, findet vorzugsweise ein Inertgas, insbesondere ein Edelgas, wie Argon, Verwendung. Hierdurch ist sichergestellt, daß an der Oberfläche des Erzeugnisses, insbesondere des Grundkörpers, keine unerwünschten chemischen Reaktionen stattfinden, sondern lediglich eine Reinigung des Erzeugnisses. Alternativ hierzu kann auch ein reaktives Gas, insbesondere Wasserstoff, zur Plasmabildung verwendet werden. Bei der Verwendung von Wasserstoff können durch das Plasma auch auf dem Erzeugnis befindliche Oxide durch eine Oxidation zu Wasser entfernt werden.

Vorzugsweise wird das Erzeugnis während der Reinigung, bei der positiv geladene Ionen auf das Erzeugnis auftreffen, um eine Rotationsachse gedreht. Hierdurch wird eine gleichmäßige Reinigung und Erwärmung des Erzeugnisses auch bei komplexen Geometrien erreicht.

Um die Reinigung möglichst schnell und effektiv durchzuführen, wird das Erzeugnis in einer besonders vorteilhaften Ausführung vor dem Reinigungsvorgang erhitzt. Infolge der Erwärmung verdampft oder gast ein Großteil der auf der Oberfläche sowie im Erzeugnis befindlichen Verunreinigungen aus. Insbesondere das Ausgasen von im Körper des Erzeugnisses befindlichen Verunreinigungen ist hierbei von großem Vorteil im Hinblick auf die Bauteileigenschaften. Die sich an diese thermische Reinigungsphase anschließende Reinigungsphase mittels Ionenbeschuß (Sputtern) wird dadurch effektiver. Die Vorerwärmung des Erzeugnisses vor dem Sputtern ist daher vor allem auch in wirtschaftlicher Hinsicht, nicht zuletzt wegen der Zeitersparnis, von besonderer Bedeutung. Diese Ausführung mit Vorheizen ist dabei nicht auf die Ausgestaltung mit Abfluss der Elektronen über einen Schalter zum Bezugspotential, beispielsweise Massepotential, begrenzt. Sie ist vielmehr unabhängig von der speziellen Weise der Einstellung des Potentialniveaus des Erzeugnisses.

Das Erzeugnis wird während der Reinigung vorzugsweise gleichzeitig auf eine Temperatur, die gleich groß oder höher ist als die Beschichtungstemperatur, welche insbesondere über 800 °C liegt, aufgeheizt. Die Beheizung auf eine Temperatur oberhalb der Beschichtungstemperatur hat den positiven Effekt, dass bei der anschließenden Beschichtung mit geringerer Temperatur eine vergleichsweise geringe Ausgasung auftritt. Diese Aufheizung kann mittels des Elektronenstrahls erreicht werden, der gleichzeitig dazu dient, ein steuerbares negatives Potential des Grundkörpers zu erzeugen.

Das Verfahren zur Reinigung und gegebenenfalls gleichzeitigen Aufheizung des Erzeugnisses ist vorzugsweise in einen Prozeß zur Beschichtung des Erzeugnisses mit einer Schutzschicht, insbesondere einer Wärmedämmschicht, integriert. Die zweitgenannte auf ein Verfahren zur Beschichtung eines Erzeugnisses gerichtete Aufgabe wird erfindungsgemäß mithin dadurch gelöst, daß das Erzeugnis vor dem eigentlichen Beschichtungsprozeß in der vorher beschriebenen Weise durch ein Plasma vorgereinigt wird.

Vorzugsweise wird das Verfahren zur Herstellung einer Wärmedämmschicht als Elektronenstrahl-Bedampfungsverfahren (Electron-Beam-Physical-Vapour Deposition; EB-PVD) oder als reaktives Gasfluß-Sputterverfahren, wie es beispielsweise in der WO 98/13531 A1 beschrieben ist, durchgeführt.

Im Rahmen des gesamten Beschichtungsprozesses wird vorzugsweise vor der Reinigung das Erzeugnis bereits auf eine Temperatur vorgeheizt, die insbesondere oberhalb der eigentlichen Beschichtungstemperatur des Erzeugnisses, welche über 800 °C liegt, beträgt. Wie bereits ausgeführt, erhöht dies die Effektivität des Reinigens mittels Ionen-Beschuß. Das Aufheizen erfolgt beispielsweise mit Hilfe des Elektronenstrahls und/oder einer weiteren Heizeinrichtung. Nach der Reinigung wird das Erzeugnis auf die Beschichtungstemperatur aufgeheizt, wobei hierunter auch zu verstehen ist, daß bereits während des Reinigens ein Aufheizen auf die Beschichtungstemperatur stattgefunden hat, so daß das Erzeugnis nach der Reinigung sich auf der Beschichtungstemperatur befindet. Vorzugsweise schließen sich Vorheizung, Reinigung und Beschichtung unmittelbar aneinander an, wobei durch die Vorheizung bereits eine erste Reinigungswirkung erzielt wird und wobei im Verlauf der eigentlichen Reinigung zwischen Sputtervorgang und Heizphase (mittels Elektronenbeschuß) geschaltet werden kann. Die unmittelbare Aneinanderreihung der drei Prozesse Vorheizen, Reinigen und Beschichten gewährleistet, dass das Erzeugnis immer auf einem ausreichend hohen Temperaturniveau gehalten wird.

Das eigentliche Reinigungsverfahren wird hierbei vorzugsweise in einer Kammer, im folgenden als Substratkammer bezeichnet, durchgeführt. Diese kann eine Vorheizkammer einer Beschichtungsanlage, die eigentliche Beschichtungskammer oder eine separate eigens für die Reinigung ausgeführte Kammer sein. Zur Erzeugung des Elektronenstrahls, welcher der elektrischen Aufladung des Grundkörpers dient, kann eine Elektronenstrahlkanone verwendet werden, die ebenfalls zur Durchführung des Beschichtungsprozesses verwendet wird oder entsprechend nur für die Reinigung oder eine Beheizung ausgelegt ist. Eine solche Elektronenstrahlkanone kann bis zu 150 kW Elektronenstrahlleistung aufweisen mit einer Beschleunigungsspannung von bis zu 35 kV.

Die auf eine Vorrichtung zur Reinigung eines Erzeugnisses, insbesondere eines Bauteils einer Gasturbine, gerichtete Aufgabe wird durch eine Vorrichtung gelöst, die eine Substratkammer aufweist, in der eine Substratführung mit einer Substrathalterung zur Halterung des Erzeugnisses vorgesehen ist, wobei die Substratführung mechanisch fest, aber elektrisch isoliert mit der Substrathalterung verbunden ist, und die Substrathalterung über eine elektrische Ableitung und mittels eines in der Ableitung angeordneten Schalters mit Bezugspotential verbindbar ist. Das Bezugspotential kann dabei beispielsweise Massepotential oder Erdpotential sein.

Bevorzugt ist der Schalter mit einer Steuereinrichtung zum Steuern des abwechselnden Öffnens und Schließens des Schalters verbunden. Dadurch ist es möglich, den Schalter mit einer fest vorgegebenen, mit einer einstellbaren oder mit einer geregelten Frequenz zu betätigen.

Die Substratkammer kann hierbei die eigentliche Beschichtungskammer einer Beschichtungsanlage, eine Vorheizkammer einer Beschichtungsanlage oder eine separate Kammer darstellen.

Die Ableitung ist vorzugsweise mit einer Strom- und/oder Spannungsmeßeinrichtung verbunden, so daß der Elektronenstrom durch die Ableitung sowie eine Vorspannung zwischen dem Grundkörper und einem in der Substratkammer vorhandenen Plasma gemessen werden kann. Das Plasma selbst wird vorzugsweise durch einen Beschuß des Grundkörpers mit einem Elektronenstrahl aus einer Elektronenstrahlkanone erzeugt. Die Elektronenstrahlkanone kann hierbei innerhalb der Substratkammer oder außerhalb dieser angeordnet sein und speziell für den Beschuß des Grundkörpers, beispielsweise zum Zwecke der Beheizung, ausgebildet sein. Es kann auch eine Elektronehstrahlkanone verwendet werden, die dem Beschuß eines Beschichtungs-Targets zur Herstellung einer Beschichtung auf dem Grundkörper dient. Vorzugsweise ist die Strom- und/oder Spannungsmeßeinrichtung mit der Steuereinrichtung verbunden.

Weiter bevorzugt ist zur Regelung der Schaltfrequenz des Schalters ein Regler vorgesehen, dem ein Sollwert vorgegeben ist. Ein Frequenzsollwert für den Regler kann dabei z.B. über einen Stromsollwert und/oder einen Spannungssollwert festgelegt sein.

Vorzugsweise ist die Substratkammer eine Beschichtungskammer einer Beschichtungsanlage und der Substrathalter sowie die Substratführung dienen nach der Reinigung des Erzeugnisses auch gleichzeitig der Halterung des Erzeugnisses während der Beschichtung mit einer Schutzschicht, insbesondere einer Wärmedämmschicht. Das Erzeugnis ist während der Reinigung in der Substrathalterung gehaltert, die gegenüber Substratführung, welche als Anode dient, elektrisch isoliert ist. Die Substrathalterung bildet mit der Ableitung einen Strompfad, der steuerbar, d.h. schaltbar ist. Die Substrathalterung ist so ebenfalls auf das gleiche Potential wie die Substratführung, vorzugsweise auf Erdpotential (Masse) gebracht. Über die Frequenz des schaltbaren Strompfades, welcher über die elektrische Ableitung gebildet ist, können die Parameter wie Vorspannung, Geschwindigkeit der positiven Plasmaionen usw. so eingestellt werden, daß eine besonders gute Reinigungswirkung je nach verwendetem Erzeugnis entsteht.

Das Erzeugnis ist vorzugsweise ein Bauteil einer thermischen Maschine, insbesondere einer Gasturbine, wie einer stationären Gasturbine mit dem Einsatzgebiet in der Kraftwerkstechnik oder ein Bauteil einer Flugtriebwerksturbine. Das Erzeugnis kann hierbei als ein Hitzeschild einer Brennkammer oder als eine Turbinenschaufel, eine Turbinenlaufschaufel oder eine Turbinenleitschaufel ausgebildet sein.

Die Schutzschicht, insbesondere Wärmedämmschicht, ist vorzugsweise keramisch. Sie kann Zirkonoxid (ZrO₂) oder ein anderes für den Einsatz bei hohen Temperaturen geeignetes keramisches Material, insbesondere ein Metalloxid, aufweisen. Ein Zirkonoxid ist vorzugsweise mit Yttriumoxid (Y₂O₃) oder einem anderen Oxid eines Elementes der Seltenen Erden teil- oder vollstabilisiert.

Der Grundkörper ist vorzugsweise metallisch ausgeführt. Für Anwendungen bei hohen Temperaturen mit entsprechenden Anforderungen an Korrosionsbeständigkeit, eignen sich besonders Nickel- und/oder Kobaltbasislegierungen, wie sie beispielhaft unter anderem in der US-PS 4,405,659 angegeben sind.

Zwischen Grundkörper und Wärmedämmschicht ist vorzugsweise eine Haftvermittlerschicht angeordnet. Diese kann aus einer Legierung aus Eisen, Kobalt und/oder Nickel mit Chrom, Aluminium, Yttrium bestehen. Anstelle von oder zusätzlich zu Yttrium kann eines der Elemente der Gruppe IIIb des Periodensystems einschließlich der Actiniden und der Lanthaniden sowie zusätzlich oder alternativ Rhenium enthalten sein. Solche Yttrium aufweisenden Legierungen sind in der Literatur unter der Bezeichung "MCrAlY"-Legierung zu finden. Legierungen, die gegenüber dem Anteil an Yttrium deutlich mehr Rhenium enthalten, können als "MCrAlRe"-Legierung bezeichnet werden. Zwischen der Haftvermittlerschicht und der Wärmedämmschicht kann eine Oxidschicht, insbesondere aus Aluminiumoxid, Chromoxid und/oder Galliumoxid, vorgesehen sein. Eine solche Oxidschicht kann bereits als Oxid aufgebracht sein oder infolge nachträglicher Oxidation (Thermally Grown Oxid, TGO) im Laufe der Zeit entstehen.

Ein Verfahren sowie eine Vorrichtung zur Reinigung und zur Beschichtung eines Erzeugnisses werden nachfolgend beispielhaft anhand eines Ausführungsbeispiels erläutert. Es zeigen teilweise schematisiert und nicht maßstabsgerecht
- FIG 1: eine Turbinenlaufschaufel,
- FIG 2: einen Querschnitt durch eine Turbinenschaufel,
- FIG 3: einen Aussschnitt durch ein Wärmedämmschichtsystem der Turbinenschaufel gemäß FIG 2 und
- FIG 4: eine Beschichtungsanlage zur Beschichtung einer Turbinenschaufel mit einer Wärmedämmschicht.

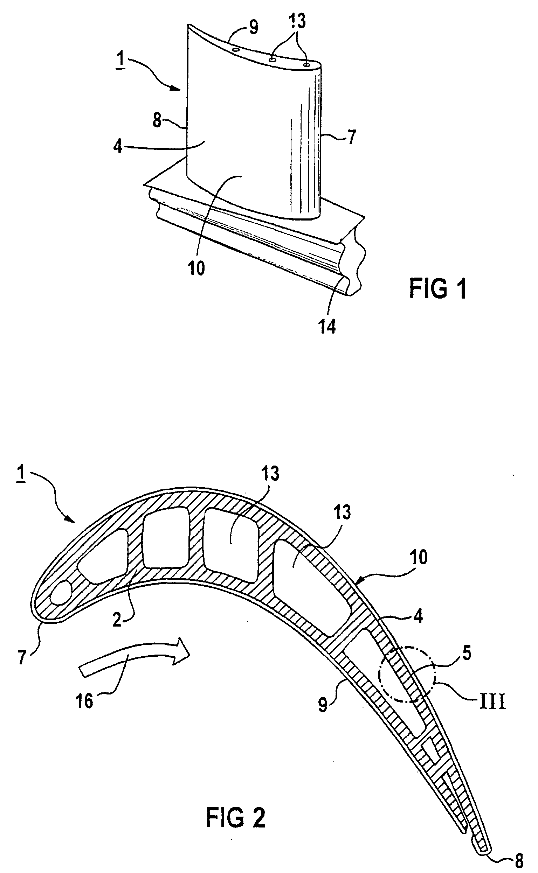

In FIG 1 ist in einer perspektivischen Ansicht als Erzeugnis 1 eine Laufschaufel einer Turbine, insbesondere einer Gasturbine, dargestellt. Die Laufschaufel 1 aus Eisen, Kobalt und/oder Nickel weist einen Schaufelfuß 14 auf, mit dem sie in einer nicht dargestellten drehbaren Turbinenwelle befestigt werden kann. An den Schaufelfuß 14 schließt sich der eigentliche Schaufelblattbereich an, welcher sich von einer Anströmkante 7 zu einer Abströmkante 8 über einerseits eine Druckseite 9 und andererseits eine Saugseite 10 erstreckt. In dem eigentlichen Schaufelblattbereich sind Kühlkanäle 13 zur Führung eines Kühlmediums, insbesondere von Kühlluft, vorgesehen. Der Schaufelblattbereich besitzt eine Oberfläche 4 mit unterschiedlich gekrümmten Oberflächenbereichen.

In FIG 2 ist in einem Querschnitt als Erzeugnis 1 eine Gasturbinenschaufel dargestellt, die während eines Einsatzes in einer nicht gezeigten Gasturbine von einem Heißgas 16 umströmt wird. Im Querschnitt erstreckt sich die Turbinenschaufel 1 von einer Anströmkante 7 über eine Druckseite 9 und eine Saugseite 10 zu einer Abströmkante 8. Die Turbinenschaufel 1 ist aus einem Grundkörper 2 gebildet, in dessen Inneren mehrere Kühlkanäle 13 zur Führung von Kühlluft vorgesehen sind. Die gesamte Oberfläche 4 der Turbinenschaufel 1 ist mit einer Wärmedämmschicht 5 beschichtet.

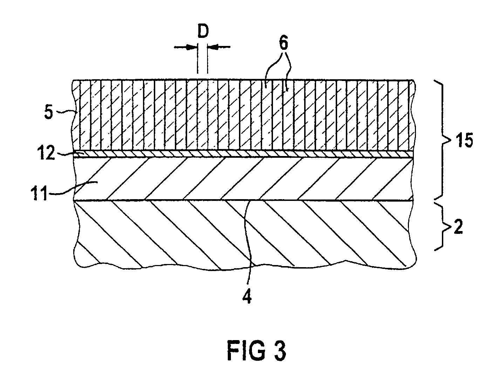

In FIG 3 ist schematisch der Aufbau eines Wärmedämmschichtsystems 15 dargestellt. Das Wärmedämmschichtsystem 15 ist auf dem Grundkörper 2 aufgebracht. Es weist unmittelbar an den Grundkörper 2 angrenzend eine Haftvermittlerschicht 11, daran angrenzend eine Oxidschicht 12 und auf der Oxidschicht 12 die eigentliche Wärmedämmschicht 5 auf. Die Haftvermittlerschicht 11 kann eine bekannte Legierung der Art MCrAlY oder MCrAlRe sein. Die Oxidschicht 12 kann im wesentlichen aus einem Aluminiumoxid bestehen oder alternativ oder zusätzlich Metalloxide, wie Chromoxid oder Galliumoxid, aufweisen. Die Wahl der Haftvermittlerschicht 11 sowie der Oxidschicht 12 richtet sich selbstverständlich nach dem Material des Grundkörpers 2 sowie der aufzubringenden Wärmedämmschicht 5, die beispielsweise aus teilstabilisiertem Zirkonoxid bestehen kann. Die Wärmedammschicht 5 weist eine Feinstruktur mit Keramikstengeln 6 auf, die im wesentlichen senkrecht zur Oberfläche 4 des Grundkörpers 2 orientiert sind. Die Keramikstengel 6 weisen jeweils einen mittleren Stengeldurchmesser D auf, welcher bei einer Schichtdicke der Wärmedämmschicht 5 von etwa 100 µm bis 200 µm im Bereich zwischen 0,5 und 5 µm, vorzugsweise unterhalb 2,5 µm, liegt.

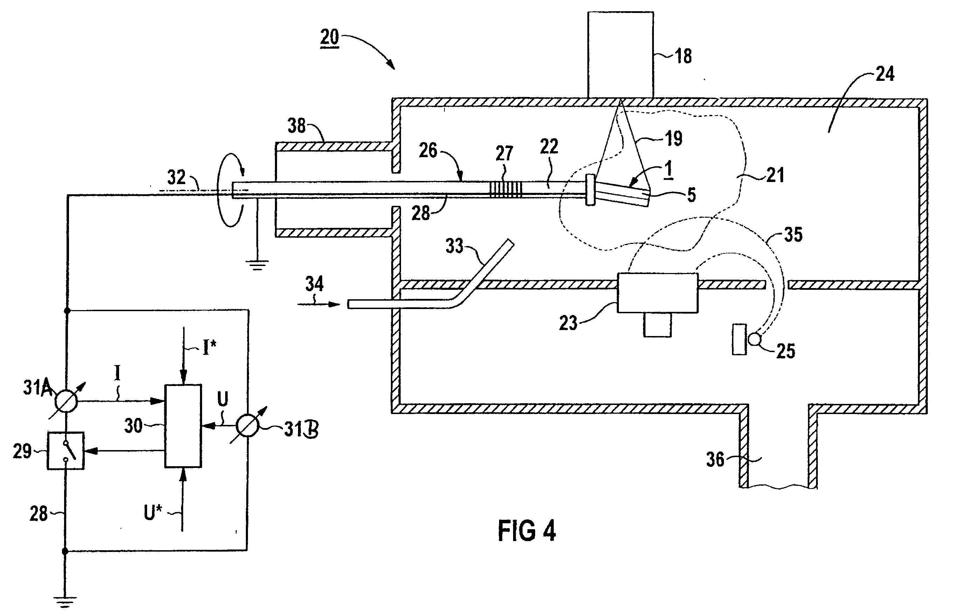

In FIG 4 ist in einem schematischen Längsschnitt eine Vorrichtung 20 zur Reinigung eines Erzeugnisses 1 dargestellt, die in eine Beschichtungsvorrichtung zum Aufbringen einer Wärmedämmschicht 5 auf dem Erzeugnis 1, insbesondere auf einer Gasturbinenschaufel, integriert ist. Die Vorrichtung 20 weist eine Substratkammer 24 auf, die als Beschichtungskammer dient. In dieser ist ein geeigneter Unterdruck (Vakuum) einstellbar, und es ist ein Gas, insbesondere ein Inertgas, eingeführt. Zur Erzeugung des Unterdrucks sind nicht dargestellte Pumpen vorgesehen, mit. denen die Substratkammer 24 über einen Pumpauslaß 36 verbunden ist. Über eine Einführkammer 38 ist eine sich entlang einer Rotationsachse 32 erstrekkende Substratführung 26, welche beispielsweise als ein hohlzylindrisches Rohr ausgeführt ist, in die Substratkammer 24 eingeführt. An die Substratführung 26 schließt sich mechanisch fest mit dieser verbunden eine Substrathalterung 22 an. In der Substrathalterung 22 ist das Erzeugnis 1 drehbar, gegebenenfalls auch schwenkbar, gehaltert. Die Substratführung 26 ist von der Substrathalterung 22 durch eine Isolierung 27 elektrisch isoliert. Außerhalb der Substratkammer 24 ist die Substratführung 26 geerdet.

Die Substrathalterung 22 ist mit einer elektrischen Ableitung 28 verbunden, welche beispielsweise durch die Substratführung 26 hindurchgeführt ist. In der elektrischen Ableitung 28 ist eine Meßeinrichtung 31A, 31B angeordnet, insbesondere zur Messung eines elektrischen Stroms I eine Strommeßeinrichtung 31A sowie zur Messung einer elektrischen Vorspannung U eine Spannungsmeßeinrichtung 31B. Weiterhin ist in der Ableitung 28 ein durch eine Steuereinrichtung 30 steuerbarer Schalter 29 vorgesehen. Der Schalter 29 kann als mechanischer oder elektronischer Schalter oder als geeigneter Steuermechanismus ausgeführt sein. Wesentlich ist seine Funktion der Steuerung des durch die Ableitung 28 fließenden elektrischen Stroms I. Die Ableitung 28 ist ebenfalls außerhalb der Substratkammer 24 an ein Bezugspotential, welches Masse oder Erde sein kann, angeschlossen. Der Schalter 29 sowie die Meßeinrichtung 31A, 31B sind mit einer Steuereinrichtung 30 verbunden, durch die der Schalter 29 steuerbar ist, so daß der Schalter 29 in einer über die Steuereinrichtung 30 vorgebbaren Frequenz öffnet und schließt. Die für das Öffnen und Schließen verwendete Frequenz bzw. Ein- und Ausschaltdauer kann in Abhängigkeit der über die Meßeinrichtung 31A, 31B bestimmten Vorspannung U erfolgen. Die Frequenz kann auch über einen Stromsollwert I* und/oder einen Spannungssollwert U* festgelegt sein, wobei der Stromsollwert I* und/oder der Spannungssollwert U* in die Steuereinrichtung 30 eingegeben werden und in der Steuereinrichtung 30 mit den Istwerten U, I verglichen werden. Die Steuersignale für den Schalter 29 werden von der Steuereinrichtung 30 auf den Schalter 29 gegeben.

An der Substratkammer 24 oberhalb der Substrathalterung 22 ist eine Elektronenstrahlkanone 18 vorgesehen, durch die ein Elektronenstrahl 19 erzeugt wird. Der Elektronenstrahl 19 kann dabei, wie gezeigt, fächerförmig oder kegelförmig als Elektronenstrahlfächer bzw. -kegel ausgebildet sein. Unter Nutzung der Erdung der Substratführung 26 und der steuerbaren Erdung (Bezugspotential) des Substrathalters 22 wird der Elektronenstrahl 19 in Richtung des Erzeugnisses 1 geführt. Auf dem Weg zu dem Erzeugnis 1 führt der Elektronenstrahl 19 zu einer Ionisierung des sich in der Substratkammer 24 befindenden-Gases, beispielsweise eines Inertgases wie Argon. Hierdurch wird ein Plasma 21 in der Umgebung des Erzeugnisses 1 gebildet. Die von dem Elektronenstrahl 19 auf das Erzeugnis 1 auftreffenden Elektronen werden über die Ableitung 28 bei geschlossenem Schalter 29 abgeführt.

Bei geöffnetem Schalter 29 kommt es vor dem Erzeugnis 1 zu einem Elektronenstau, d.h. zu einer negativ geladenen Elektronenwolke um das Erzeugnis 1, wodurch eine Beschleunigung der positiv geladenen Ionen des Plasmas 21 in Richtung des Erzeugnisses 1 stattfindet. Die so beschleunigten positiven Ionen treffen auf dem Erzeugnis 1 auf und führen somit zu einer Entfernung von Verunreinigungen auf dem Erzeugnis 1.

Durch den ständigen Wechsel zwischen einem Öffnen und Schließen des Schalters 29 kommt es mithin zu einer frequenzabhängig wechselnden Ladung und Entladung des Erzeugnisses 1, so daß eine Wechselspannungsentladung (Plasmabildung) gezündet bzw. aufrechterhalten wird. Auf diese Weise wird eine ständige Reinigung des Erzeugnisses 1 und eine Oberflächenaktivierung vor einem Beschichtungsvorgang ermöglicht. Über den Schalter 29 und die Steuereinrichtung 30 wird vorzugsweise eine Hochfrequenz-Umschaltung derart eingestellt, dass eine von der Geometrie des Erzeugnisses 1 unabhängige Reinigungswirkung erzielt wird. Dies führt zu einer besonders effektiven und homogenen Oberflächenreinigung.

In der Substratkammer 24, welche gleichzeitig die Beschichtungskammer einer Beschichtungsanlage darstellt, ist geodätisch unterhalb des Erzeugnisses 1 ein Beschichtungs-Target 23, beispielsweise aus Zirkon oder Zirkonoxid, angeordnet. In der Substratkammer 24 ist eine weitere Elektronenstrahlkanone 25 zur Erzeugung eines weiteren Elektronenstrahls 35 vorgesehen. Für die eigentliche Durchführung der Beschichtung des Erzeugnisses 1 weist die Substratkammer 24 eine Zuführung 33 für ein sauerstoffhaltiges Gas 34 auf, so daß eine zusätzliche Oxidation für eine metallkeramische Wärmedämmschicht erreichbar'ist. Das Erzeugnis 1 ist beispielsweise eine Gasturbinenschaufel oder ein Hitzeschildelement mit einer Schutzschicht, insbesondere mit einer Wärmedämmschicht aus einer Keramik. Während des eigentlichen Beschichtungsvorgangs wird das Beschichtungs-Target 23 geerdet. Der Elektronenstrahl 35 wird zum Beschichtungs-Target 23 hin abgelenkt (gestrichelt dargestellt), und er trifft nunmehr auf das Beschichtungs-Target 23 und führt dort zu einem Verdampfen des Materials des Beschichtungs-Targets 23, insbesondere Zirkon oder Zirkonoxid. Das so verdampfende Material strömt in Richtung des Erzeugnisses 1 und scheidet sich dort, gegebenenfalls unter gleichzeitiger Oxidation, als Schutzschicht (Wärmedämmschicht) ab. Das Erzeugnis 1 wird hierbei um die Rotationsachse 32 gedreht, indem die gesamte Substratführung 26 über einen nicht dargestellten Motor um die Rotationsachse 32 gedreht wird. Eine Drehung des Erzeugnisses 1 um die Rotationsachse 32 findet ebenfalls während des Reinigungsvorgangs mittels Plasma-Ionen statt. Auch während der Beschichtung kann die Plasmaentladung und somit der Ionenbeschuß des Substrats 1 aufrechterhalten werden und so eine Zwischenreinigung erzielt werden.

In dem dargestellten Beispiel läßt sich der vollständige Beschichtungsprozeß in der Substratkammer 24 durchführen. Bevorzugt wird in einem ersten Verfahrensschritt das Erzeugnis 1 ohne Anwesenheit eines ein Plasma 21 bildenden Gases über einen Elektronenstrahl 19 auf eine Temperatur oberhalb der eigentlichen Beschichtungstemperatur aufgeheizt. Dies führt in vorteilhafter Weise zu einer thermischen Vorab-Reinigung aufgrund der Verdampfung/Ausgasung von Verunreinigungen. In einem zweiten Verfahrensschritt findet bei nunmehr vorhandenem, das Plasma 21 bildenden Gas ein erneuter Beschuß mit dem Elektronenstrahl 19 statt, wodurch gleichzeitig eine Reinigung des Erzeugnisses 1 über das Plasma 21 und eine Aufheizung des Erzeugnisses 1 über den Elektronenstrahl 19 erreicht wird. Aufgrund der thermischen Vorab-Reinigung ist diese End-Reinigung mittels Ionen-Beschuß (Sputtern) wesentlich rascher und effektiver durchzuführen. Nach Beendigung der Reinigung des Erzeugnisses 1 ist dieses auf die Beschichtungstemperatur aufgeheizt, und es erfolgt ein Elektronenbeschuß des Beschichtungs-Targets 23, wodurch die Schutzschicht 5, insbesondere eine Wärmedämmschicht, auf das Erzeugnis 1 aufgebracht wird. Durch die über das Plasma 21 erfolgte Reinigung des Erzeugnisses 1 ist die Haftung der Wärmedämmschicht an das Erzeugnis 1 besonders gut.

## Patentansprüche

1. Verfahren zur Oberflächenreinigung eines Erzeugnisses (1), welches einen metallischen Grundkörper (2) aufweist, wobei ein Plasma (21) mit elektrisch positiv geladenen Ionen erzeugt wird und die Ionen in Richtung des Erzeugnisses (1) beschleunigt werden, so daß auf dem Grundkörper (2) zur Reinigung auftreffen, wobei ein Elektronenstrahl (19) auf den Grundkörper (2) gerichtet wird, und wobei der Abfluß von auf dem Grundkörper (2) auftreffenden Elektronen gesteuert wird, indem der Grundkörper (2) über einen Schalter (29) mit fest vorgegebener, mit einstellbarer oder mit geregelter Frequenz mit einem Bezugspotential verbunden wird.

2. Verfahren nach Anspruch 1, bei dem eine elektrische Ableitung (28) für den Abfluß der Elektronen über den Schalter (29) abwechselnd geöffnet und geschlossen wird.

3. Verfahren nach Anspruch 1 oder 2, bei dem der Abfluß von Elektronen mit einer Frequenz von einigen Hz bis einigen MHz, insbesondere bei etwa 50 kHz oder bei etwa 27 MHz, gesteuert wird.

4. Verfahren nach einem der vorhergehenden Ansprüche, bei dem der Abfluß von Elektronen so gesteuert wird, daß sich eine Vorspannung zwischen dem elektrisch positiv geladenen Plasma (21) und dem Grundkörper (2) von etwa 100 V bis 1000 V einstellt.

5. Verfahren nach einem der vorhergehenden Ansprüche, bei dem eine Vorspannung zwischen dem elektrisch positiv geladenen Ionen des Plasmas (21) und dem Grundkörper (2) bestimmt wird.

6. Verfahren nach einem der vorhergehenden Ansprüche, bei dem das Plasma (21) durch einen Elektronenstrahl (19) erzeugt wird.

7. Verfahren nach einem der vorhergehenden Ansprüche, bei dem das Plasma (21) von einem Inertgas, insbesondere Edelgas, wie Argon, gebildet wird.

8. Verfahren nach einem der vorhergehenden Ansprüche, bei dem das Plasma (21) von einem Reaktivgas, insbesondere Wasserstoff, gebildet wird.

9. Verfahren nach einem der vorhergehenden Ansprüche, bei dem das Erzeugnis (1) vor der Reinigung erwärmt wird, insbesondere durch Bestrahlung mit Elektronen.

10. Verfahren nach einem der vorhergehenden Ansprüche, bei dem gleichzeitig mit der Reinigung eine Aufheizung des Erzeugnisses (1) auf eine Beschichtungstemperatur, insbesondere von über 800 °C, durchgeführt wird.

11. Verfahren nach einem der vorhergehenden Ansprüche, bei dem die Oberfläche (4) eines als ein Bauteil einer Gasturbine ausgeführten Erzeugnisses (1), insbesondere einer Turbinenschaufel oder eines Hitzeschildelementes, gereinigt wird.

12. Verfahren nach einem der vorhergehenden Ansprüche, bei dem das Erzeugnis (1) um eine Rotationsachse (32) gedreht wird.

13. Verfahren zur Beschichtung eines Erzeugnisses (1), bei dem das Erzeugnis (1) gemäß dem Verfahren nach einem der vorhergehenden Ansprüche gereinigt und anschließend mittels physikalischer Abscheidung aus der Dampfphase (PVD) mit einer Schutzschicht (5) beschichtet wird.

14. Verfahren nach Anspruch 13, bei dem das Erzeugnis (1) vor der Reinigung auf eine Temperatur, insbesondere oberhalb der Beschichtungstemperatur, aufgeheizt und nach der Reinigung vor dem Beschichtungsprozeß auf die Beschichtungstemperatur, insbesondere von über 800 °C, aufgeheizt wird.

15. Vorrichtung zur Reinigung eine Erzeugnisses (1), insbesondere eines Bauteils einer Gasturbine, mit einer Substratkammer (24), in der eine Substratführung (26) vorgesehen ist, welche Substratführung (26) mechanisch fest und elektrisch isoliert mit einer Substrathalterung (22) zur Halterung des Erzeugnisses (1) verbunden ist, welche Substrathalterung (22) über eine elektrische Ableitung (28) und mittels eines in der Ableitung (28) angeordneten Schalters (29) mit einem Bezugspotential verbindbar ist, wobei eine Elektronenstrahlkanone (18) zur Erzeugung eines auf das Erzeugnis (1) gerichteten Elektronenstrahls (19) in der Vorrichtung angeordnet ist.

16. Vorrichtung nach Anspruch 15, bei der der Schalter (29) mit einer Steuereinrichtung (30) zum Steuern des abwechselnden Öffnens und Schließens des Schalters (29) verbunden ist.

17. Vorrichtung nach Anspruch 15 oder 16, bei der die Ableitung (28) mit einer Strom- und/oder Spannungsmeßvorrichtung (31) verbunden ist.

18. Vorrichtung nach Anspruch 17,
**dadurch gekennzeichnet, daß** die Strom- und/oder Spannungsmeßvorrichtung (31) mit der Steuereinrichtungt (30) verbunden ist.

19. Vorrichtung nach einem der Ansprüche 15 bis 18,
**dadurch gekennzeichnet, daß** zur Regelung der Schaltfrequenz des Schalters (19) ein Regler vorgesehen ist, dem ein Sollwert (U*, I*) vorgegeben ist.

## Claims

1. Process for cleaning the surface of a product (1) which has a metallic base body (2), in which process a plasma (21) with electrically positively charged ions is generated and the ions are accelerated toward the product (1), so that they come into contact with the base body (2) for cleaning purposes, an electron beam (19) being directed onto the base body (2), and in which process the outgoing flux of electrons which come into contact with the base body (2) is controlled as a result of the base body (2) being connected to a reference potential via a switch (29) with a fixedly preset, adjustable or regulated frequency.

2. Process according to Claim 1, in which an electric outgoing line (28) for the outgoing flux of electrons is alternately opened and closed by means of the switch (29).

3. Process according to Claim 1 or 2, in which the outgoing flux of electrons is controlled at a frequency of a few Hz to a few MHz, in particular at approximately 50 kHz or at approximately 27 MHz.

4. Process according to one of the preceding claims, in which the outgoing flux of electrons is controlled in such a way that a bias voltage of approximately 100 V to 1000 V is established between the electrically positively charged plasma (21) and the base body (2).

5. Process according to one of the preceding claims, in which a bias voltage between the electrically positively charged ions of the plasma (21) and the base body (2) is determined.

6. Process according to one of the preceding claims, in which the plasma (21) is generated by an electron beam (19).

7. Process according to one of the preceding claims, in which the plasma (21) is formed by an inert gas, in particular noble gas, such as argon.

8. Process according to one of the preceding claims, in which the plasma (21) is formed by a reactive gas, in particular hydrogen.

9. Process according to one of the preceding claims, in which the product (1) is heated before being cleaned, in particular by irradiation with electrons.

10. Process according to one of the preceding claims, in which, at the same time as the cleaning, the product (1) is heated to a coating temperature, in particular of over 800°C.

11. Process according to one of the preceding claims, in which the surface (4) of a product (1) which is designed as a component of a gas turbine, in particular a turbine blade or a heat shield element, is cleaned.

12. Process according to one of the preceding claims, in which the product (1) is rotated about an axis of rotation (32).

13. Process for a coating product (1), in which the product (1) is cleaned using the process according to one of the preceding claims and is then coated with a protective layer (5) by means of physical vapour deposition (PVD).

14. Process according to Claim 13, in which the product, before being cleaned, is heated to a temperature, in particular a temperature above the coating temperature, and after the cleaning and prior to the coating process is heated to the coating temperature, in particular of over 800°C.

15. Device for cleaning a product (1) in particular a component of a gas turbine, having a substrate chamber (24) in which a substrate guide (26) is provided, which substrate guide (26) is connected in a mechanically fixed and electrically insulated manner to a substrate holder (22) for holding the product (1), which substrate holder (22) can be connected to a reference potential by means of an electrical outgoing line (28) and by means of a switch (29) arranged in the outgoing line (28), an electron beam gun (18) for generating an electron beam (19), which is directed on to the product (1), being arranged in the device.

16. Device according to Claim 15, in which the switch (29) is connected to a control device (30) for controlling the alternating opening and closing of the switch (29).

17. Device according to Claim 15 or 16, in which the outgoing line (28) is connected to a current- and/or voltage-measuring device (31).

18. Device according to Claim 17, **characterized in that** the current- and/or voltage-measuring device (31) is connected to the control device (30).

19. Device according to one of Claims 15 to 18, **characterized in that** a regulator, for which a desired value (U*, I*) is preset, is provided for the purpose of regulating the switching frequency of the switch (19).

## Revendications

1. Procédé de nettoyage en surface d'un produit (1) qui a un corps (2) métallique, un plasma (21) ayant des ions chargés positivement du point de vue électrique étant produit et les ions étant accélérés en direction du produit (1) de manière à venir heurter le corps (2) pour le nettoyage, un faisceau (19) d'électrons étant dirigé sur le corps (2) et l'évacuation des électrons venant heurter le corps (2) étant commandée par le fait que le corps (2) est relié à un potentiel de référence par l'intermédiaire d'un interrupteur (29) à fréquence prescrite fixe réglable ou réglée.

2. Procédé suivant la revendication 1, dans lequel une ligne (28) électrique pour l'évacuation des électrons est alternativement ouverte et fermée par l'interrupteur (29).

3. Procédé suivant la revendication 1 ou 2, dans lequel l'évacuation des électrons est commandée à une fréquence de quelques Hz à quelques MHz notamment d'environ 54 kHz ou d'environ 27 MHz.

4. Procédé suivant l'une des revendications précédentes, dans lequel l'évacuation des électrons est commandée de façon à ce qu'il s'établisse une tension de polarisation entre le plasma (21) chargé positivement du point de vue électrique et le corps (2) d'environ 100 V à 1000 V.

5. Procédé suivant l'une des revendications précédentes, dans lequel il est déterminé une tension de polarisation entre les ions chargés positivement du point de vue électrique du plasma (21) et le corps (2).

6. Procédé suivant l'une des revendications précédentes, dans lequel le plasma (21) est produit par un faisceau (19) d'électrons.

7. Procédé suivant l'une des revendications précédentes, dans lequel le plasma (21) est formé d'un gaz inerte, notamment d'un gaz rare comme l'argon.

8. Procédé suivant l'une des revendications précédentes, dans lequel le plasma est formé d'un gaz réactif, notamment d'hydrogène.

9. Procédé suivant l'une des revendications précédentes, dans lequel le produit (1) est chauffé avant le nettoyage notamment par exposition à des électrons.

10. Procédé suivant l'une des revendications précédentes, dans lequel on effectue en même temps que le nettoyage un chauffage du produit (1) en le portant à une température de revêtement notamment supérieure à 800°C.

11. Procédé suivant l'une des revendications précédentes, dans lequel on nettoie la surface d'un produit (1) réalisé sous la forme d'un élément d'une turbine à gaz, notamment d'une aube de turbine ou d'un élément formant bouclier thermique.

12. Procédé suivant l'une des revendications précédentes, dans lequel on fait tourner le produit (1) par rapport à un axe (32) de rotation.

13. Procédé de revêtement d'un produit (1), dans lequel on nettoie le produit (1) suivant le procédé de l'une des revendications précédentes, et ensuite on le revêt au moyen d'un dépôt physique en phase vapeur (PVD) d'une couche (5) de protection.

14. Procédé suivant la revendication 13, dans lequel on porte le produit (1) avant le nettoyage à une température notamment supérieure à la température de revêtement et après le nettoyage, on le porte avant l'opération de revêtement à la température de revêtement notamment supérieure à 800°C.

15. Dispositif de nettoyage d'un produit (1), notamment d'un élément d'une turbine à gaz comprenant une chambre (24) de substrat, dans laquelle il est prévu un dispositif (26) de guidage du substrat, lequel dispositif (26) de guidage du substrat est relié mécaniquement d'une manière rigide et électriquement d'une manière isolée, à un dispositif (22) de maintien du substrat destiné à maintenir le produit (1), le dispositif (22) de maintien du substrat pouvant être relié à un potentiel de référence par une ligne (28) électrique et au moyen d'un interrupteur (29) monté dans la ligne (28), un canon (18) à faisceau d'électron destiné à produire un faisceau (19) d'électron dirigé sur le produit (1) étant monté dans le dispositif.

16. Dispositif suivant la revendication 15, dans lequel l'interrupteur (29) est relié à un dispositif (30) de commande destiné à commander l'ouverture et la fermeture en alternance de l'interrupteur (29).

17. Dispositif suivant la revendication 15 ou 16, dans lequel la ligne (28) est reliée à un dispositif (31) de mesure de l'intensité et/ou de la tension.

18. Dispositif suivant la revendication 17, **caractérisé en ce que** le dispositif (31) de mesure de l'intensité et/ou de la tension est relié au dispositif (30) de commande.

19. Dispositif suivant l'une des revendications 15 à 18, **caractérisé en ce que** pour la régulation de la fréquence de commutation de l'interrupteur (19), il est prévu un régulateur auquel est prescrite une valeur (U*, I*) de consigne.
